Europäisches Patentamt

(19) European Patent Office

Office européen des brevets

(11) Numéro de publication: **0 036 360**
**B1**

(12) FASCICULE DE BREVET EUROPEEN

(45) Date de publication du fascicule du brevet:
**07.03.84**

(21) Numéro de dépôt: **81400370.3**

(22) Date de dépôt: **10.03.81**

(51) Int. Cl.³: **C 30 B 23/02,** C 30 B 25/02,
C 30 B 29/12

(54) Procédé de croissance d'un monocristal dans une enceinte tubulaire fermée.

(30) Priorité: **11.03.80 FR 8005404**

(43) Date de publication de la demande:
**23.09.81 Bulletin 81/38**

(45) Mention de la délivrance du brevet:
**07.03.84 Bulletin 84/10**

(84) Etats contractants désignés:
**BE CH DE GB LI LU NL**

(56) Documents cités:
**FR - A - 2 276 872**
**FR - A - 2 315 994**
**US - A - 4 094 268**

(73) Titulaire: **CENTRE NATIONAL D'ETUDES SPATIALES,**
**129, Rue de l'Université, F-75007 Paris (FR)**

(72) Inventeur: **Cadoret, Robert Marcel Marie H., 3, Rue Emile**
**Zola, F-63400 Chamalieres (FR)**
Inventeur: **Omaly, Jean Eugène Marie, 11,Avenue**
**Jocelin Bargoin, F-63130 Royat (FR)**
Inventeur: **Robert, Marc Antonin, 12, Rue des Malandes,**
**F-15000 Auriliac (FR)**

(74) Mandataire: **De Boisse, Louis, 37, Avenue Franklin D.**
**Roosevelt, F-75008 Paris (FR)**

ACTORUM AG

Procédé de croissance d'un monocristal dans une enceinte tubulaire fermée

L'invention concerne un procédé de croissance d'un monocristal dans une enceinte tubulaire fermée.

Le brevet français No 2276872 a proposé de préparer des monocristaux de $HgI_2$ dans une ampoule maintenue sous un vide poussé à l'aide d'une pompe à vide et comprenant trois zones: une zone de sublimation contenant une charge de $HgI_2$ polycristallin portée à une température suffisante pour que ce dernier se sublime à l'état de vapeur; une zone de transfert intermédiaire portée à une température sensiblement constante supérieure à celle de la zone de sublimation, et une zone de croissance du monocristal de $HgI_2$ portée à une température inférieure ou égale à celle de la zone de sublimation. La zone de transfert est rapprochée en continu de la charge au fur et à mesure de la croissance du monocristal. Ce procédé est compliqué à mettre en œuvre car il nécessite l'emploi d'une pompe à vide et d'un four mobile à plusieurs enroulements. En outre, il est difficile de contrôler les différents paramètres qui gouvernent la germination et la croissance afin d'obtenir des monocristaux sans défauts structuraux rédhibitoires.

D'autres procédés, encore plus compliqués, ont été décrits dans le brevet français No 2315994 et le brevet des E.U.A. No 4094268.

Il existe donc un besoin pour un procédé de production de monocristaux de bonne qualité et de haute pureté en enceinte fermée qui soit relativement simple à mettre en œuvre, n'exige pas d'installations compliquées et onéreuses, et permette un bon contrôle des paramètres.

Le but de l'invention est de fournir un tel procédé.

L'invention concerne un procédé de croissance d'au moins un monocristal, selon lequel :

A) on place une source du matériau devant former le monocristal, ce matériau étant choisi parmi : I) un matériau vaporisable ou sublimable, avec ou sans dissociation à l'état de vapeur, et II) un matériau réactif susceptible d'une réaction réversible avec un gaz réactif en donnant un composé gazeux, à l'une des extrémités d'une enceinte de forme générale cylindrique,

B) soit on fait le vide dans l'enceinte dans le cas où la source est formée d'un matériau vaporisable ou sublimable, soit on remplit l'enceinte de gaz réactif, dans le cas où la source est formée d'un matériau réactif, puis on ferme hermétiquement ladite enceinte,
ledit procédé étant caractérisé en ce que:

C) on chauffe l'enceinte de manière à créer dans celle-ci une zone de source et une zone de dépôt et de puits à températures uniformes différentes, la zone de source incluant la source de matériau et étant chauffée à une température $T_s$ à laquelle se produit la vaporisation ou sublimation ou la réaction du matériau et la zone de dépôt et de puits incluant l'extrémité de l'enceinte opposée à la source et étant chauffée à une température $T_p$ inférieure à $T_s$ dans le cas d'un processus exothermique et supérieure à $T_s$ dans le cas d'un processus endothermique, température $T_p$ à laquelle de la vapeur se condense ou du composé se dissocie en donnant le matériau solide désiré avec dépôt de matière sur un puits localisé préalablement formé dudit matériau ou d'au moins l'un des constituants de celui-ci, situé à cette extrémité ou au voisinage de celle-ci, et les zones à températures uniformes différentes étant reliées par une zone de transition à gradient de température,

D) à régler l'écart de température $\Delta T$ entre la zone de source et la zone de puits et de dépôt à une valeur convenable pour que se produise la nucléation d'au moins un germe discret dans la zone de dépôt de l'enceinte en un point situé en amont du puits, et

E) à régler la valeur de l'écart de température $\Delta T$, dès l'apparition du ou des germes, afin d'éviter la nucléation d'autres germes et de régler la vitesse de croissance convenable du ou des monocristaux.

Le puits de matière peut être formé, par exemple, juste avant l'étape C en chauffant l'enceinte, à l'exception de la zone de puits, à une température bien supérieure à celle de la zone de puits. Cette façon de réaliser le puits de matière est particulièrement utile lorsqu'on utilise un tube de verre scellé sous vide comme enceinte cylindrique. Si c'est pratiquement possible, comme par exemple dans le cas d'une enceinte cylindrique démontable, on pourrait se contenter de déposer à l'extrémité puits un peu du matériau solide désiré ou (dans le cas d'un alliage) au moins l'un de ses constituants.

La formation d'un puits bien localisé avant de procéder aux étapes suivantes est utile pour éviter que la matière déposée ne tapisse toute la zone de dépôt et de puits et pour obtenir un flux gazeux régulier.

Le procédé de l'invention repose sur l'établissement d'un régime convectif ou diffusionnel forcé par création d'une ou de plusieurs chutes de pression partielle des espèces transportées $\delta P_i$ entre les extrémités d'une enceinte cylindrique fermée (appelée ci-après simplement tube) par la mise en place d'une source $A_s$ et d'un puits de matière $A_p$ maintenus respectivement à des températures $T_s$ et $T_p$ différentes.

Le procédé est applicable à tout transport régi par une réaction du type:

$$mA_{solide} + nBm_{gaz} \rightleftarrows m(ABn)_{gaz} \qquad (1)$$

A la source, il y a production de l'espèce source gazeuse (ABn).

Au dépôt, la phase solide est créée avec disparition de l'espèce source gazeuse ABn.

D'autres réactions plus complexes peuvent prendre place à la source comme au puits.

Le procédé de l'invention est applicable à la préparation de monocristaux de types très divers. Des exemples non limitatifs sont $\alpha$-HgI$_2$, HgSe, CdS, Pb$_x$Sn$_{1-x}$Te, Ge, etc.

La croissance du ou des monocristaux peut se faire directement sur la paroi interne de l'enceinte cylindrique ou sur un support ou piédestal disposé dans la zone de dépôt de l'enceinte. On peut notamment effectuer des dépôts de couches monocristallines de germanium sur des substrats appropriés, par exemple de germanium monocristallin ou d'alumine. Dans le cas d'un dépôt sur substrat, il faut, le plus souvent, préparer le substrat par chauffage des zones source et dépôt afin de diriger les impuretés désorbées du substrat vers la zone puits, avant de mettre en œuvre le procédé de l'invention.

Une réaction de sublimation-condensation congruente est un cas particulier pour lequel aucun constituant gazeux B n'est nécessaire au transport de la phase solide A. Dans ce cas, on a simplement

$$A_{solide} \rightleftharpoons A_{gaz} \quad \text{à la source}$$

$$A_{gaz} \rightleftharpoons A_{solide} \quad \text{au dépôt}$$

$\alpha$-HgI$_2$ est un exemple particulièrement intéressant d'une telle réaction de sublimation-condensation congruente.

Dans le cas d'$\alpha$-HgI$_2$, l'étape E consiste avantageusement à réduire l'écart de température $\delta T$ établi dans l'étape D, dès l'apparition du ou des germes discrets, afin d'éviter la nucléation d'autres germes, et cela jusqu'à ce que le ou les monocristaux se développant sur le ou les germes atteignent un volume d'au moins 1 mm$^3$ environ, puis à augmenter finalement cet écart de température pour accroître la vitesse de croissance du ou des monocristaux.

Selon une variante de mise en œuvre du procédé de l'invention, la zone de dépôt et de puits est scindée en deux zones distinctes, à savoir une zone de dépôt et une zone de puits chauffées à des températures uniformes différentes $T_d$ et $T_p$, respectivement, la zone de dépôt se trouvant entre la zone de source et la zone de puits, et la relation $T_s > T_d > T_p$ étant satisfaite dans le cas d'un processus exothermique, et la relation $T_s < T_d < T_p$ dans le cas d'un processus endothermique. Avec cette variante, les étapes D et E s'appliquent à l'écart de température existant entre la zone de source et la zone de dépôt.

Outre les matières essentielles sus-décrites, on peut, si on le désire, introduire dans l'enceinte un gaz additionnel inerte destiné à permettre de contrôler le gradient de concentration entre la source et le puits et donc à régler le flux diffusionnel de l'espèce transportée.

La description qui va suivre, faite avec référence aux dessins annexés, fera bien comprendre l'invention. Sur les dessins:

la fig. 1 est un graphique illustrant la courbe de la sursaturation de la phase vapeur en fonction de la distance à partir de la source dans le cas de l'emploi d'un four à deux zones de chauffage;

la fig. 2 est un graphique similaire à celui de la fig. 1, mais dans le cas de l'emploi d'un four à trois zones de chauffage;

la fig. 3 est une vue schématique illustrant la mise en œuvre du procédé de l'invention.

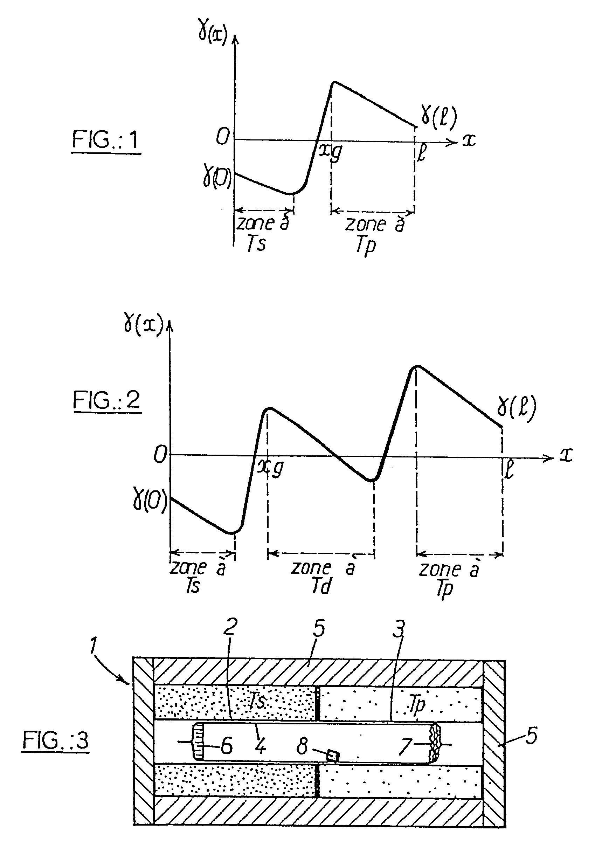

La fig. 1 illustre un profil type de la courbe de la sursaturation relative $\gamma(x)$ en fonction de la distance x à partir de la source, dans le cas de l'emploi d'un four à deux zones. $\gamma(x)$ est égal, dans le cas d'une réaction de sublimation-condensation congruente, à l'expression

$$\gamma_{(x)} = \frac{P(x)}{Pe(Tx)} - 1$$

où Pe(Tx) = pression d'équilibre à la température T à la distance x de la source = K(Tx) (constante d'équilibre), et

P(x) = pression partielle du composé sublimé au point x.

Dans le cas d'une réaction chimique, on a

$$\gamma_{(x)} = \frac{P(ABn)^m}{P(Bm)^n K(T_X)} - 1$$

où K(Tx) = constante d'équilibre de la réaction (1) à la température Tx; et P(ABn)$^m$ et P(Bm)$^n$ sont les pressions partielles des constituants ABn et Bm. Pour des valeurs de $T_s$ et $T_p$ données, la valeur maximale de $\gamma$ augmente avec l'inverse de la distance de la position moyenne $x_g$ du gradient, donc par réduction de la longueur de la zone de source. De la même façon, pour des valeurs de $T_s$, $T_p$ et $x_g$ données, cette valeur maximale diminuera avec l'inverse de la longueur du tube. Un four à deux zones permet ainsi de régler la vitesse du flux gazeux par le choix de $T_s - T_p$, de la longueur, du rayon du tube et des surfaces de la source et du puits, et la fréquence de nucléation et la cinétique par le choix des paramètres précédents, de $T_p$ et de la position $x_g$ du gradient de température. C'est en début de la zone de dépôt que $\gamma(x)$ atteint sa valeur maximale, et c'est donc en ce point que la fréquence de nucléation et la cinétique de croissance seront les plus élevées.

Dans le cas où la constante d'équilibre K(Tx) ne varie pas suffisamment avec la température, il sera préférable d'utiliser un four à trois zones isothermes: une zone source à $T_s$, une zone de dépôt à $T_d$, et une zone puits à $T_p$. La vitesse du flux gazeux dépendra des cinq paramètres, $T_s - T_p$, R, 1, $S_s$ et $S_p$.

$\gamma(x) = \gamma(0) < 0$ pour x = 0, décroît jusqu'à une valeur d'autant plus négative que la position moyenne $x_g$ du gradient qui sépare les zones source et dépôt est éloignée de la source. Elle croît ensuite du fait de la décroissance de K(T), de la valeur K($T_s$) à la valeur K($T_d$) jusqu'à une valeur d'autant plus élevée que $x_g$ est faible, pour décroître ensuite. Elle recroît ensuite dans la zone du second gradient pour redécroître jusqu'à la valeur $\gamma(1)$. Si la différence entre les températures des zones dépôt et puits est grande, le second gradient sera étendu. Il conviendra donc de choisir un tube suffisamment long pour maintenir une zone dépôt isotherme.

La fig. 2 illustre un profil typique de la courbe $\gamma(x)$ en fonction de x dans le cas de l'emploi d'un four à trois zones. La fréquence de nucléation et la cinétique de croissance dépendent de $\gamma(x)$ et $T_d$. Le four à trois zones permet donc de régler indépendamment la vitesse du flux gazeux et la cinétique de nucléation et de croissance par les choix indépendants de $T_s - T_p$ et de $T_s - T_d$.

Dans la pratique, on pourra opérer, par exemple, comme suit, dans le cas d'une réaction de sublimation-condensation congruente.

*Cas d'un four à deux zones:*

En premier lieu, on introduit de la matière source et puits dans le tube. Le diamètre du tube sera choisi en fonction de la limite du procédé. Cette limite est obtenue lorsque le cristal a une surface telle qu'il prend environ la moitié de la matière qui provient de la source. Elle dépend donc de la surface de la source et de celle du puits. Un choix d'une surface de source et de puits au moins égale à la surface du cristal désiré est une bonne garantie. De la même façon, le choix de la section du tube doit être tel que le cristal désiré n'obstrue pas plus du quart de la section. Pour un tube de 18 mm de diamètre, la taille d'un cristal cubique ne devra pas être supérieure à 4 à 5 mm de côté. La longueur du tube doit être suffisante pour obtenir un flux important et une sursaturation maximale pas trop élevée. Des essais préalables sont nécessaires.

La matière qui doit constituer la source et le puits est introduite dans le tube scellé sous vide propre. Elle est placée à une extrémité du tube. Le tube est ensuite placé dans un four à deux zones de chauffage, par exemple un four à circulation d'huile ou un four à caloducs, l'extrémité du tube n'ayant pas de matière étant placée dans la zone à température moins élevée. Le puits est constitué par transport de la matière de la zone source vers la zone puits sous une forte différence de températures $T_s - T_p$. D'autres méthodes sont possibles pour constituer le puits (voir l'exemple 1).

Des essais de nucléation sont alors conduits de façon à choisir une différence de température $T_s - T_p$ qui permette d'obtenir un nombre de germes discrets espacés d'une distance au moins égale à la taille des cristaux à développer. Les germes sont localisés au début de la zone de dépôt et de puits là où $\gamma(x)$ atteint sa valeur maximale. Le nombre de germes créés doit rester stable pendant quelques jours, c'est-à-dire jusqu'à ce qu'ils aient une taille suffisante pour que la quantité de matière absorbée par la croissance appauvrisse suffisamment l'environnement des cristaux.

Ces essais effectués, l'expérience est reprise, en partant d'un écart de température nul et en l'accroissant petit à petit, jusqu'à une valeur inférieure ou égale à celle des essais. Dès l'apparition de germes discrets, l'écart est légèrement réduit. Le temps d'apparition peut aller de 1 h à plus de 1 d. Ce sont les valeurs de $T_p$ et de $\Delta T$ qui permettent de contrôler la fréquence de nucléation. Tant que le ou les cristaux ne font pas plus d'environ 1 mm³, on maintient inchangées les conditions. Après, l'écart $\Delta T$ est augmenté de façon à augmenter le flux gazeux. La taille limite apparaît lorsque la surface du cristal est attaquée du côté tourné vers le puits. Il convient alors d'arrêter le chauffage. Si l'on poursuivait la croissance, les faces avant du cristal continueraient alors à croître, tandis que les faces arrière se détérioreraient.

Les expériences, dans les mêmes conditions de pression en composés actifs ou inertes, sont reproductibles pour une même valeur des paramètres: surface de source, de puits, longueur du tube, position de la zone de transition $(x_g)$.

*Cas d'un four à trois zones:*

Dans ce cas, on commence par établir une différence de température $T_s - T_p$ qui donne une vitesse de condensation dans la zone de puits suffisante, par exemple de plus de 0,5 mm d'épaisseur par jour. On peut, par exemple, faire cette détermination en plaçant un cristal dans la zone puits et en mesurant sa vitesse de croissance ou encore en plaçant un support de verre recouvert de microcristaux et en mesurant la quantité déposée, cela sur des tubes témoins. Cela étant fait, les essais de nucléation sont effectués par la recherche de l'écart entre les températures source $T_s$ et dépôt $T_d$ de la même façon que pour le four à deux zones.

Ces essais sont effectués pour une vitesse de flux gazeux donnés. On peut donc rechercher à partir des écarts $T_s - T_p$ et $T_s - T_d$ la nucléation de germes discrets avec la vitesse de flux la plus grande. Celle-ci peut, d'autre part, être augmentée par augmentation de $T_s - T_p$. Un réajustement de $T_d$ peut alors se montrer nécessaire pour éviter un dépôt trop rapide ou une attaque du ou des cristaux, selon les cas. La taille limite possible est ainsi supérieure à celle d'un four à deux zones. L'emploi d'un four à trois zones constitue un mode de mise en œuvre préféré, spécialement pour une production à l'échelle industrielle.

Le procédé de l'invention peut être mis en œuvre avec l'enceinte cylindrique en position horizontale ou verticale. L'expression enceinte cylindrique doit être prise dans un sens large et veut dire simplement que la majeure partie de l'enceinte est de forme cylindrique. Il n'est pas exclu, en particulier, que les parties extrêmes de l'enceinte contenant la source et le puits aient une configuration différente de celle du reste de l'enceinte. L'enceinte peut être simplement formée d'un tube de verre scellé sous vide ou par des éléments assemblables munis de joints d'étanchéité et des vannes nécessaires au fonctionnement de l'ensemble.

Le procédé de l'invention est applicable, comme on l'a dit, à des composés vaporisables ou sublimables ou à des composés solides capables de subir une réaction réversible avec un gaz réactif en donnant un composé gazeux.

Le procédé de l'invention est spécialement intéressant pour la production de monocristaux de $\alpha\text{-}HgI_2$ qui sont utiles dans des détecteurs de rayons X et $\gamma$. Dans le cas de $\alpha\text{-}HgI_2$, la température

$T_s$ utilisée ne doit pas, bien entendu, excéder la température de transformation en β-$HgI_2$. On a trouvé que, pour α-$HgI_2$, on peut utiliser une température $T_s$ comprise dans la gamme de 50 à 125° C et un écart de température entre les zones de source et de dépôt allant de 0,1° C (dans l'étape E) à 10° C environ.

L'enceinte doit être soigneusement nettoyée et le composé formant source doit être soigneusement purifié pour éviter que le monocristal ne contienne une proportion indésirable d'impuretés. Le vide fait dans l'enceinte à l'étape B doit être très poussé, par exemple de l'ordre de $10^{-7}$ Torr.

Les exemples non limitatifs suivants sont donnés pour illustrer l'invention:

*Exemple 1:*

*Préparation d'un monocristal d'iodure mercurique de forme α*

Dans cet exemple, on a utilisé une installation telle que représentée sur la fig. 3. Cette installation comprenait essentiellement un four en verre à circulation d'huile thermostatée comprenant deux zones de chauffage 2 et 3 de même longueur, épousant la forme de l'enceinte tubulaire 4. Cette dernière était constituée d'un simple tube de verre scellé à ses deux extrémités et était disposée à l'horizontale. L'ensemble était soigneusement revêtu de matière calorifuge 5 pour éviter toute perturbation venue de l'extérieur. L'iodure mercurique utilisé est un iodure mercurique du commerce à 99% purifié par au moins trois sublimations successives dans une ampoule de verre scellée sous $10^{-6}$ Torr à la température ambiante, les ampoules ayant été nettoyées avec du Decon " 90 (une solution de décontamination) et rincées à la vapeur d'eau bidistillée pendant 12 h au préalable.

L'enceinte tubulaire employée avait un diamètre de 15 mm et une longueur de 150 mm et avait été nettoyée au Decon " 90 et rincée à la vapeur d'eau bidistillée pendant 12 h.

On a placé 20 g de $HgI_2$ purifié à l'une des extrémités de l'enceinte tubulaire puis, avant de sceller définitivement le tube, on l'a dégazé pendant plusieurs jours sur la pompe à vide.

On a alors effectué les dépôts source 6 et puits 7 en effectuant deux opérations de sublimation-condensation successives, chacune des extrémités jouant successivement le rôle de source (zone chaude) et de puits (zone froide). Le produit adhère aux extrémités du tube et présente un aspect microcristallisé. Les surfaces de sublimation et de condensation dépendent de l'écart de température utilisé et peuvent être accrues au moyen de pointes Vigreux prévues aux deux extrémités du tube. Dans le cas du présent exemple, les surfaces de la source et du puits étaient similaires et égales à 23,5 mm² environ.

Les dépôts source et puits ayant été effectués, on a alors chauffé la zone de source à 107° C et la zone de dépôt et de puits à 105° C. Le temps d'apparition d'un germe sur la paroi du tube au voisinage du début de la zone de dépôt et de puits est de 12 à 24 h.

Une fois que le cristal 8 a atteint un volume de 1 mm³ environ, on a porté ΔT à 7° C en diminuant $T_p$ à 100° C. La taille limite du cristal apparaît à 4,5 mm de côté. La vitesse de croissance du cristal était de 0,2 à 0,3 mm/d.

*Exemple 2:*

On a répété l'exemple 1, mais on a utilisé une enceinte tubulaire de plus grand diamètre (25 mm) et de même longueur (150 mm).

Dans ce cas, la taille limite du monocristal est de l'ordre de 7 à 8 mm de côté.

Il est à noter que, au lieu d'effectuer la nucléation et la croissance du monocristal sur la paroi interne du tube, on pourrait effectuer celles-ci sur un support ou piédestal disposé dans l'axe du tube, en particulier dans le cas où l'enceinte est disposée à la verticale.

*Exemple 3:*

Dans cet exemple, on a procédé comme à l'exemple 1, mais le four employé comprenait trois zones de chauffage, l'enceinte cylindrique était constituée d'un tube de 30 cm de long et de 30 mm de diamètre. La zone source faisait 8 cm de long et était à 115° C; la zone dépôt faisait 15 cm de long et était à 112,8° C, et la zone puits faisait 7 cm de long et était à 105° C.

On a pu obtenir un monocristal de 7 × 4 × 17 mm.

*Exemple 4:*

*Préparation de monocristaux de $Pb_{0,8}Sn_{0,2}Te$*

On a utilisé un four à deux zones comme à l'exemple 1. Avec des températures $T_s$=820° C et $T_p$=815° C, on a pu obtenir 4 monocristaux de 4 à 10 mm de côté au bout de 6 d.

Il va de soi que les modes de réalisation décrits ne sont que des exemples et qu'ils pourraient être modifiés, notamment par substitution de moyens techniques équivalents, sans que l'on sorte pour cela du cadre de la présente invention.

**Revendications**

1. Procédé de croissance d'au moins un monocristal, selon lequel:

A) on place une source (6) du matériau devant former le monocristal, ce matériau étant choisi parmi: I) un matériau vaporisable ou sublimable, avec ou sans dissociation à l'état de vapeur, et II) un matériau réactif susceptible d'une réaction réversible avec un gaz réactif en donnant un composé gazeux, à l'une des extrémités d'une enceinte (4) de forme générale cylindrique,

B) soit on fait le vide dans l'enceinte dans le cas où la source est formée d'un matériau vaporisable ou sublimable, soit on remplit l'enceinte de gaz réactif, dans le cas où la source est formée d'un matériau réactif, puis on ferme hermétiquement ladite enceinte,

procédé caractérisé en ce que:

C) on chauffe l'enceinte de manière à créer dans celle-ci une zone de source et une zone de dépôt et de puits à températures uniformes différentes, la zone de source incluant la source de matériau et étant chauffée à une température $T_s$ à laquelle se produit la vaporisation ou sublimation ou la réaction du matériau, et la zone de dépôt et de puits incluant l'extrémité de l'enceinte opposée à la source et étant chauffée à une température $T_p$ inférieure à $T_s$ dans le cas d'un processus exothermique et supérieure à $T_s$ dans le cas d'un processus endothermique, température $T_p$ à laquelle de la vapeur se condense ou du composé se dissocie en donnant le matériau solide désiré avec dépôt de matière sur un puits (7) localisé préalablement formé dudit matériau ou d'au moins l'un des constituants de celui-ci, situé à cette extrémité ou au voisinage de celle-ci, et les zones à températures uniformes différentes étant reliées par une zone de transition à gradient de température,

D) à régler l'écart de température $\Delta T$ entre la zone de source et la zone de puits et de dépôt à une valeur convenable pour que se produise la nucléation d'au moins un germe discret dans la zone de dépôt de l'enceinte en un point situé en amont du puits, et

E) à régler la valeur de l'écart de température $\Delta T$, dès l'apparition du ou des germes, afin d'éviter la nucléation d'autres germes et de régler la vitesse de croissance convenable du ou des monocristaux.

2. Procédé selon la revendication 1, caractérisé en ce que le matériau servant de source est un composé solide sublimable.

3. Procédé selon la revendication 2, caractérisé en ce que le matériau servant de source est de l'$\alpha$-$HgI_2$.

4. Procédé selon la revendication 3, caractérisé en ce que l'étape E consiste à réduire l'écart de température $\Delta T$ établi dans l'étape D, dès l'apparition du ou des germes discrets, afin d'éviter la nucléation d'autres germes, et cela jusqu'à ce que le ou les monocristaux se développant sur le ou les germes atteignent un volume d'au moins 1 mm³ environ, puis à augmenter finalement cet écart de température pour accroître la vitesse de croissance du ou des monocristaux.

5. Procédé selon la revendication 1, caractérisé en ce que le matériau servant de source est un composé réactif.

6. Procédé selon la revendication 1, caractérisé en ce que le matériau servant de source est le germanium.

7. Procédé selon la revendication 6, caractérisé en ce qu'on dépose une couche monocristalline de germanium sur un substrat.

8. Procédé selon l'une quelconque des revendications 1 à 7, caractérisé en ce que la zone de dépôt et de puits est scindée en une zone de dépôt et une zone de puits distinctes chauffées à des températures uniformes différentes $T_d$ et $T_p$, respectivement, la zone de dépôt se trouvant entre la zone de source et la zone de puits et la relation $T_s > T_d > T_p$ étant satisfaite.

## Patentansprüche

1. Verfahren zur Züchtung von wenigstens einem Einkristall, gemäss welchem man:

A) eine Quelle (6) eines Materials zur Bildung des Einkristalls, wobei dieses Material aus der Gruppe von I) einem Material, das mit oder ohne Dissoziation im Dampfzustand verdampfbar oder sublimierbar ist, und II) einem reaktionsfähigen Material, das zu einer reversiblen Reaktion mit einem reaktiven Gas unter Bildung einer gasförmigen Zusammensetzung geeignet ist, ausgewählt ist, an einem der Enden eines Behälters (4) einer allgemein cylindrischen Form anordnet,

B) entweder in dem Behälter in dem Fall, in welchem die Quelle aus einem verdampfbaren oder sublimierbaren Material gebildet ist, ein Vakuum erzeugt, oder den Behälter in dem Fall, in welchem die Quelle aus einem reaktiven Material gebildet ist, mit einem reaktiven Gas füllt und dann den genannten Behälter hermetisch verschliesst, dadurch gekennzeichnet, dass man

C) den Behälter in einer Weise zur Ausbildung einer Zone der Quelle (Aufgabezone) und einer Abscheidungs- und Sumpfzone in ihm bei gleichförmigen unterschiedlichen Temperaturen erhitzt, wobei die Zone der Quelle die Materialquelle enthält und auf eine Temperatur $T_s$ erhitzt wird, bei welcher die Verdampfung oder Sublimation oder die Reaktion des Materials stattfindet, und die Abscheidungs- und Sumpfzone das Ende des Behälters gegenüber der Quelle einschliesst und auf eine Temperatur $T_p$ unterhalb der Temperatur $T_s$ im Falle eines exothermen Verfahrens und oberhalb der Temperatur $T_s$ im Falle eines endothermen Verfahrens erhitzt wird, und die Temperatur $T_p$ die Temperatur ist, bei welcher der Dampf sich kondensiert oder die Zusammensetzung sich dissoziiert, wobei das gewünschte feste Material mit einer Abscheidung des Materials auf der Sumpf (7), die vorhergehend angeordnet und aus dem genannten Material oder wenigstens aus einem der Bestandteile desselben gebildet ist, und an diesem Ende oder in dessen Nähe angebracht ist, erhalten wird, und die Zonen von gleichförmigen unterschiedlichen Temperaturen über eine Übergangszone mit einem Temperaturgradienten verbunden sind,

D) den Temperaturunterschied $\Delta T$ zwischen der Zone der Quelle und der Sumpf- und Abscheidungszone auf einen geeigneten Wert regelt, damit die Kristallbildung von wenigstens einem diskreten Kristallkeim in der Abscheidungszone des Behälters an einem Punkt stattfindet, der stromaufwärts von der Sumpfzone liegt, und

E) den Wert des Temperaturunterschiedes $\Delta T$ ab dem Erscheinen eines Kristallkeimes oder von Kristallkeimen regelt, um eine Kristallkeimbildung von anderen Kristallkeimen zu vermeiden und die Geschwindigkeit des Wachstums des oder von Einkristallen in geeigneter Weise zu regeln.

2. Verfahren nach Anspruch 1, dadurch gekennzeichnet, dass das als Quelle dienende Material eine feste sublimierbare Zusammensetzung ist.

3. Verfahren nach Anspruch 2, dadurch gekennzeichnet, dass das als Quelle dienende Material $\alpha$-HgI$_2$ ist.

4. Verfahren nach Anspruch 3, dadurch gekennzeichnet, dass die Stufe (E) darin besteht, dass man den in der Stufe (D) errichteten Temperaturunterschied $\Delta$T sogleich nach dem Erscheinen eines diskreten Kristallkeims oder von diskreten Kristallkeimen verringert, um die Kristallkeimbildung von anderen Kristallkeimen zu verhindern und dies so lange, bis der oder die Einkristalle, die sich auf dem oder den Kristallkeimen entwickeln, ein Volumen von wenigstens etwa 1 mm$^3$ erreicht bzw. erreichen, und dann schliesslich den Temperaturunterschied zur Erhöhung der Geschwindigkeit des Wachstums des Einkristalls oder der Einkristalle vergrössert.

5. Verfahren nach Anspruch 1, dadurch gekennzeichnet, dass das als Quelle dienende Material eine reaktionsfähige Zusammensetzung ist.

6. Verfahren nach Anspruch 1, dadurch gekennzeichnet, dass das als Quelle dienende Material Germanium ist.

7. Verfahren nach Anspruch 6, dadurch gekennzeichnet, dass man eine monokristalline Schicht von Germanium auf einem Substrat abscheidet.

8. Verfahren nach einem der Ansprüche 1 bis 7, dadurch gekennzeichnet, dass die Abscheidungs- und Sumpfzone in eine Abscheidungszone und eine Sumpfzone getrennt ist, wobei diese getrennten Zonen auf gleichförmige verschiedene Temperaturen $T_d$ bzw. $T_p$ erhitzt werden und die Abscheidungszone sich zwischen der Zone der Quelle und der Sumpfzone befindet und die Beziehung $T_s > T_d > T_p$ erfüllt wird.

**Claims**

1. Process for the growth of at least one mono-crystal, which comprises:

(A) placing a source (6) of the material, which is to form the mono-crystal and which material is chosen among (I) a material that is vaporisable or sublimable, with or without dissociation, in the vapour state, and (II) a reactive material, capable of a reversible reaction with a reactive gas, so as to yield a gaseous compound, at one of the ends of a chamber (4) having a generally cylindrical shape,

(B) either establishing a vacuum in the chamber in the case where the source is formed by a vaporisable or sublimable material, or filling the chamber with a reactive gas in the case where the source is formed by a reactive material, and then hermetically closing said chamber, said process being characterized by:

(C) heating the chamber so as to create in the latter a source zone and a deposit and well zone, having different uniform temperatures, the source zone including the source of material and being heated to a temperature $T_s$, at which vaporisation or sublimation or reaction occurs, and the deposit and well zone including the end of the chamber opposite to the source and being heated to a temperature $T_p$, lower than $T_s$ in the case of an exothermic process and higher than $T_s$ in the case of an endothermic process, temperature $T_p$ at which vapour condenses or compound is dissociated, yielding the desired solid material with deposition of material in a localised, previously formed well (7) of said material or of at least one of the components thereof situated at the end or in the vicinity of the latter, and the zones, having different uniform temperatures, being connected by a transition zone having a temperature gradient;

(D) adjusting the temperature difference $\Delta$T between the source zone and the well and deposit zone to a suitable value, so that nucleation of a least one discrete seed takes place in the deposit zone of the chamber, at a point situated upstream the well, and

(E) adjusting the value of the temperature difference $\Delta$T, as soon as a seed or seeds appear(s), in order to prevent nucleation of other seeds and to control the suitable rate or growth of the mono-crystal or mono-crystals.

2. Process according to claim 1, wherein the material, serving as the source, is a sublimable solid compound.

3. Process according to claim 2, wherein the material, serving as the source, is $\alpha$-HgI$_2$.

4. Process according to claim 3, wherein step (E) consists in reducing the temperature difference $\Delta$T, established in step (D), from the moment of the appearance of a discrete seed or discrete seeds, in order to prevent nucleation of other seeds, and continuing until the mono-crystal or mono-crystals, developing on the seed or seeds, reach a volume of at least 1 mm$^3$, approximately, and then finally increasing that temperature difference in order to increase the rate of growth of the mono-crystal or mono-crystals.

5. Process according to claim 1, wherein the material, serving as the source, is a reactive compound.

6. Process according to claim 1, wherein the material, serving as the source, is germanium.

7. Process according to claim 6, wherein a mono-crystalline layer of germanium is deposited on a substrate.

8. Process according to anyone of the claims 1 to 7, wherein the deposit and well zone is divided into a deposit zone and a well zone, being separate and heated to different uniform temperatures $T_d$ and $T_p$, respectively, the deposit zone being located between the source zone and the well zone and the relationship $T_s > T_d > T_p$ being satisfied.

FIG.: 1

FIG.: 2

FIG.: 3